# EUROPEAN PATENT APPLICATION

(11) **EP 1 950 817 A1**
(43) Date of publication of application: **30.07.2008**
(21) Application number: 06842815.0
(22) Date of filing: 14.11.2006
(51) Int. Cl.: H01L 51/50, C09K 11/06, H05B 33/10

(54) **ORGANIC ELECTROLUMINESCENT DEVICE**

(30) Priority: 17.11.2005 JP 2005332652; 05.04.2006 JP 2006104255
(71) Applicant: Idemitsu Kosan Co., Ltd., Chiyoda-ku Tokyo 100-8321 (JP)
(72) Inventor: ARAI, Hiromasa, Sodegaura-shi, Chiba 299-0293 (JP); MORISHITA, Hironobu, Sodegaura-shi, Chiba 299-0293 (JP); HOSOKAWA, Chishio, Sodegaura-shi, Chiba 299-0293 (JP); KUMA, Hitoshi, Sodegaura-shi, Chiba 299-0293 (JP); ARAKANE, Takashi, Sodegaura-shi, Chiba 299-0293 (JP)
(74) Representative: Gille Hrabal Struck Neidlein Prop Roos
(86) International application number: PCT/JP2006/322660
(87) International publication number: WO 2007/058172

(57) **Abstract**

An organic electroluminescence device including: an emitting layer 40 between an anode 10 and a cathode 60, an acceptor-containing layer 70 which contains an acceptor and is electron-transportable, and a hole-transporting layer 30, the acceptor-containing layer and the hole-transporting layer being between the anode 10 and the emitting layer 40 in this order, the acceptor-containing layer being a continuous film formed by deposition.

## Description

### Technical Field

The invention relates to an organic electroluminescence (EL) device.

### Background Art

In general, conventional organic EL devices have the following device structure:
(1) an anode/a hole-injecting layer/a hole-transporting layer/an emitting layer/an electron-transporting layer/a cathode,
(2) an anode/a hole-transporting layer/an emitting layer/an electron-transporting layer/a cathode, or
(3) an anode/a hole-injecting layer/a hole-transporting layer/an emitting layer/an electron-transporting layer/an electron-injecting layer/a cathode.

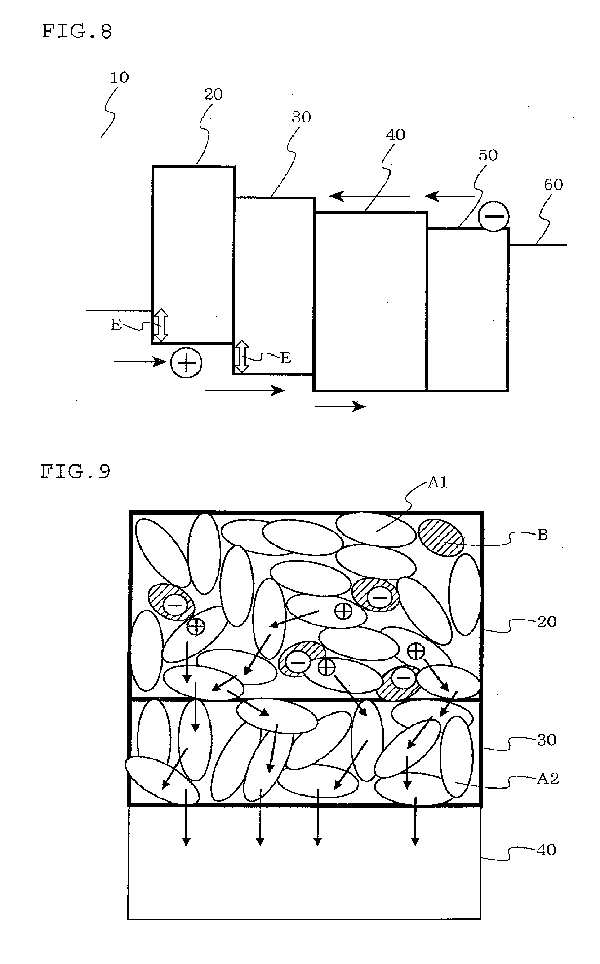

Fig. 8 shows the energy level of each of the constituting members in the organic EL devices (1).

As illustrated in Fig. 8, holes are injected from an anode 10 to a hole-injecting layer 20, and further the holes are injected from the hole-injecting layer 20 to a hole-transporting layer 30. The holes transported in the hole-injecting layer 20 and the hole-transporting layer 30 are finally injected to an emitting layer 40. On the other hand, electrons are injected from a cathode 60 to an electron-transporting layer 50, and further injected to the emitting layer 40. In the emitting layer 40, the holes are recombined with the electrons to emit light. An energy barrier E and another energy barrier E are present between the anode 10 and the hole-injecting layer 20 and between the hole-injecting layer 20 and the hole-transporting layer 30, respectively. The holes need to go over the energy barriers E, so that a voltage loss is generated. When electrons are injected from the emitting layer 40 to the hole-transporting layer 30, the electrons stay in the hole-transporting layer 30, for instance, for the following reasons: the hole-transporting layer 30 has a low electron-transporting capability, and the electron barrier is present in the interface between the hole-transporting layer 30 and the hole-injecting layer 20. Consequently, the hole-transporting layer 30 is deteriorated.

For example, an arylamine compound is conventionally used for the hole-injecting layer or the hole-transporting layer. However, the layer made of the arylamine compound is remarkably low in electron-transporting capability, and further the arylamine compound itself has no durability at the time of reduction (that is, electron injection). Consequently, in the case of aiming to extend the lifetime of an EL device, deterioration in the arylamine compound becomes a problem. Moreover, there arises a problem wherein voltage loss is caused by a high resistance of the arylamine compound layer and the applied voltage becomes high.

Thus, a technique has been discovered wherein an oxidizer or an acceptor is mixed into a hole-injecting layer in an amount of 20% or less by weight, thereby making the resistance of the hole-injecting layer low. Fig. 9 shows the motion of electrons and holes when an acceptor is added to a hole-injecting layer. The hole-injecting layer 20 is made of a hole-injecting molecule Al and the acceptor molecule B, and a hole-transporting layer 30 is made of a hole-transporting molecule A2. Holes injected from an anode (not illustrated) are transported to an emitting layer 40 by action of the hole-injecting molecule A1 in the hole-injecting layer 20 and the hole-transporting molecule A2 in the hole-transporting layer 30. The acceptor molecule B withdraws an electron from the hole-injecting molecule Al and further generates a hole. The holes generated herein are also transported to the emitting layer 40 by action of the hole-injecting molecule Al and the hole-transporting molecule A2. However, in the hole-injecting layer 20, the acceptor molecule Bs are not adjacent to each other, so that electrons are not transported.

Known techniques for mixing an oxidizer or an acceptor into such a hole-injecting layer are for example, techniques of mixing into polyaniline a low-molecular compound or polymer having a sulfonic acid group as an oxidizer (See, Non-patent Document 1 and 2, and Patent Document 1). Also known are techniques of vapor-depositing a hole-injecting material and an oxidizer simultaneously to make the resistance of a hole-injecting layer low (See, Patent Document 2 and Non-patent Document 3).

As stated above, various improvement methods of carrier injection are investigated for lower power consumption or lower operating voltage of an organic EL device.

[Patent Document 1] Japanese Patent Application Laid-open (JP-A) No. 2005-108828
[Patent Document 2] JP-A No. 11-251067
[Non-patent Document 1] Nature, Vol. 357, 477-479, 1992
[Non-patent Document 2] Applied Physics Letters, Vol. 64, 1245-1247, 1994
[Non-patent Document 3] Jpn. J. Appl. Phys., Vol. 41, 358, 2002

When these techniques are used, the applied voltage can be made low by a drop in the resistance. However, when electrons are injected to the hole-injecting layer, problems such that compounds therein are deteriorated are identified. Furthermore, there is a problem that the oxidizer aggregates so as to change with time. Accordingly, a long-lifetime device cannot be necessarily obtained.
In order to raise the capability of hole injection from the anode to the hole-injecting layer, it is necessary to reduce the injection barrier, which is decided by a difference between the work function of the anode and the ionization potential of the hole-injecting layer, as much as possible. Accordingly, a material higher in work function than ITO, which has been hitherto used as an anode, has been desired; however, a high-work-function material satisfying practical performances has not yet been discovered.
An object of the invention is to provide an organic EL device which has a long lifetime and requires only a low voltage even if various anode materials having a lower work function than ITO are used.
Another object of the invention is to provide an organic EL device which can emit light with high efficiency at a low voltage due to carrier generation caused by providing a suitable acceptor layer in the device from the above viewpoint.

### Disclosure of the Invention

According to the invention, the following organic EL device and hole-injecting material for organic EL devices can be provided.
1. An organic electroluminescence device comprising:
   an emitting layer between an anode and a cathode,
   an acceptor-containing layer, and
   a hole-transporting layer,
   the acceptor-containing layer and the hole-transporting layer being disposed between the anode and the emitting layer in this order from the anode,
   the acceptor-containing layer being a continuous film formed by deposition.
2. The organic electroluminescence device according to 1, wherein the acceptor-containing layer has a surface with a surface roughness (Ra) of 1.5 nm or less.
3. The organic electroluminescence device according to 1 or 2, wherein the reduction potential of the acceptor-containing layer is larger than the reduction potential of tetracyanoquinodimethane.
4. The organic electroluminescence device according to any one of 1 to 3, wherein the acceptor of the acceptor-containing layer is a quinoid derivative of formulae (1a) to (li), 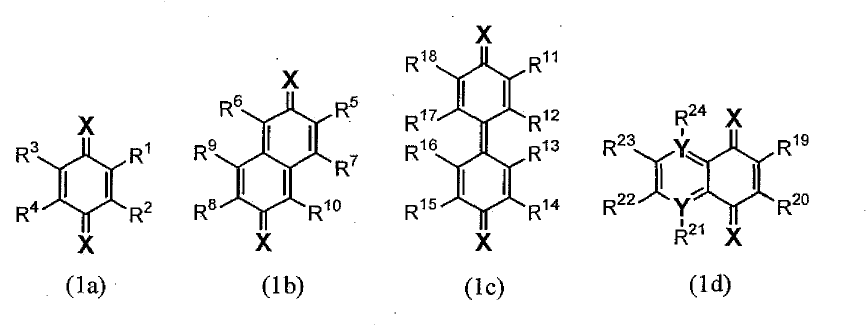 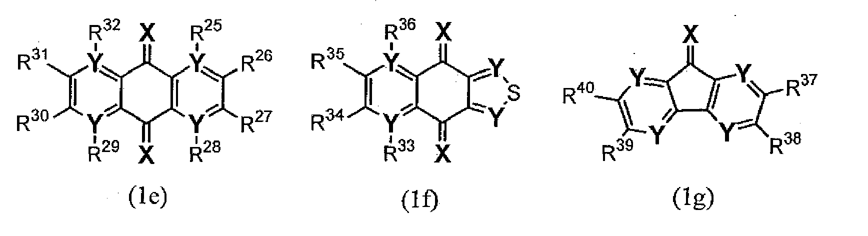 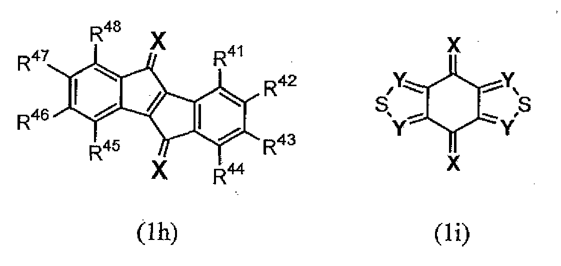 wherein R¹ to R⁴⁸ are each a hydrogen atom, halogen atom, cyano group, alkoxy group, alkyl group or aryl group, provided that derivatives of which all of R¹ to R⁴⁸ in the same molecule are hydrogen or fluorine are excluded, and
   X is an electron-withdrawing group of formulae (j) to (p), 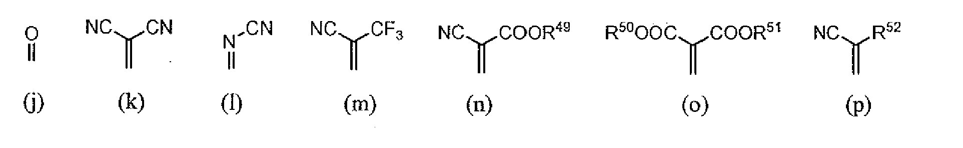 wherein R⁴⁹ to R⁵² are each a hydrogen atom, fluoroalkyl group, alkyl group, aryl group or heterocycle, and R⁵⁰ and R⁵¹ may form a ring, and
   Y is -N= or -CH=.
5. The organic electroluminescence device according to any one of 1 to 3, wherein the acceptor of the acceptor-containing layer is an arylborane derivative of formula (2a) or (2b), 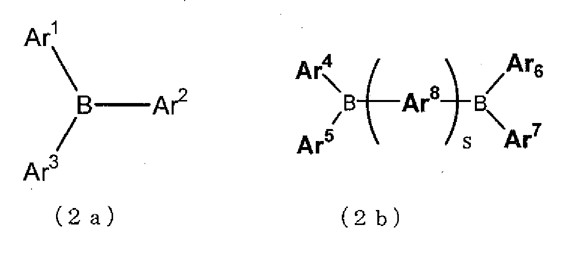 wherein Ar¹ to Ar⁸ are each an aryl group or heterocycle containing an electron-withdrawing group, and s is 1 or 2.
6. The organic electroluminescence device according to any one of 1 to 3, wherein the acceptor of the acceptor-containing layer is a thiopyranedioxide derivative of formula (3a) or a thioxanthenedioxide derivative of formula (3b), 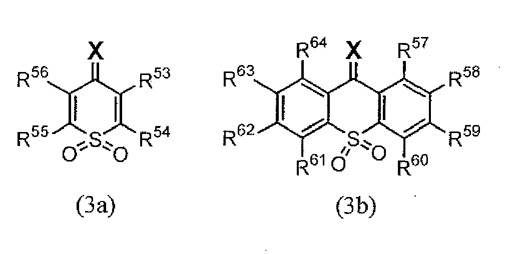 wherein R⁵³ to R⁶⁴ are each a hydrogen atom, halogen atom, fluoroalkyl group, cyano group, alkyl group or aryl group, and
   X is an electron-withdrawing group of formulae (j) to (p), 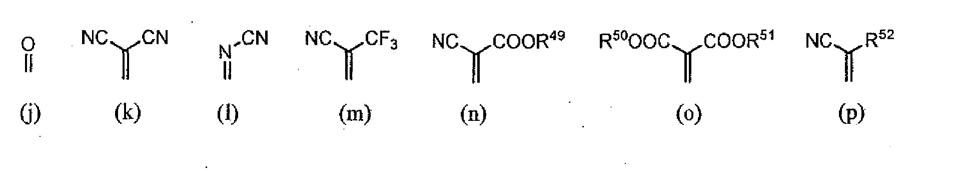 wherein R⁴⁹ to R⁵² are each a hydrogen atom, fluoroalkyl group, alkyl group, aryl group or heterocycle, and R⁵⁰ and R⁵¹ may form a ring.
7. The organic electroluminescence device according to any one of 1 to 6, wherein an electron-donating compound is added to the acceptor-containing layer in a concentration lower than the concentration of the acceptor.
8. The organic electroluminescence device according to 7, wherein the electron-donating compound is a phenylenediamine compound of formula (4), 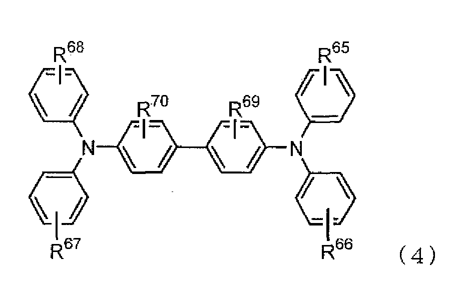 wherein R⁶⁵ to R⁶⁸ are each a hydrogen atom, halogen atom, alkyl group, aryl group, heterocycle or diarylamino group and may be joined together to form a phenyl or naphthyl group, and
   R⁶⁹ to R⁷⁰ are each a hydrogen atom, halogen atom or alkyl group.
9. The organic electroluminescence device according to any one of 1 to 8, wherein the hole-transporting layer is a phenylenediamine compound of formula (4), 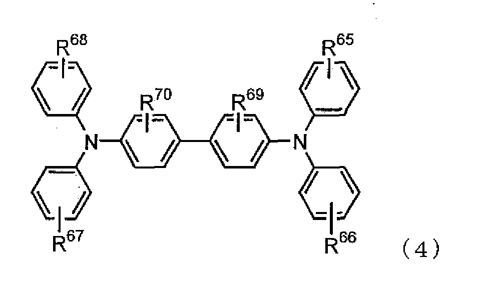 wherein R⁶⁵ to R⁶⁸ are each a hydrogen atom, halogen atom, alkyl group, aryl group, heterocycle or diarylamino group and may be joined together to form a phenyl or naphthyl group, and
   R⁶⁹ to R⁷⁰ are each a hydrogen atom, halogen atom or alkyl group.
10. The organic electroluminescence device according to any one of 1 to 9, wherein a buffer layer is interposed between the acceptor-containing layer and the hole-transporting layer.
11. The organic electroluminescence device according to 10, wherein the buffer layer is a doped layer.
12. The organic electroluminescence device according to 11, wherein the doped layer is an N-doped layer and/or a P-doped layer.
13. The organic electroluminescence device according to 10, wherein the buffer layer is a semiconductive oxide layer.
14. The organic electroluminescence device according to any one of 1 to 13, wherein electrons are transported from the buffer layer or a contacting surface between the acceptor-containing layer and the hole-transporting layer into the acceptor-containing layer toward the anode, and
   holes are transported from the buffer layer or the contacting surface between the acceptor-containing layer and the hole-transporting layer into the hole-transporting layer toward the emitting layer.
15. A hole-injecting material for an organic electroluminescence device comprising a quinoid derivative of formulae (1a) to (li) recited in 4.

According to the invention, an organic EL device which has a long lifetime and requires only a low driving voltage can be provided. The material used in its anode can be appropriately selected from various materials ranging from metals having a low work function to ITO independently of the ionization potential of the organic material.

### Brief Description of the Drawings

Fig. 1 is a sectional view illustrating a first embodiment of the organic EL device according to the invention.
Fig. 2 is a view for explaining the motion of electrons and holes in an acceptor-containing layer, a hole-transporting layer and an emitting layer in the organic EL device in Fig. 1.
Fig. 3 is a diagram showing the energy level of each of the constituting members in the organic EL device in Fig. 1.
Fig. 4 is a sectional view illustrating a second embodiment of the organic EL device according to the invention.
Fig. 5 is a view for explaining the states of a continuous film (a) and non-continuous film (b).
Fig. 6 is a TEM photograph showing a section of a compound A layer formed in Example 1.
Fig. 7 is a TEM photograph showing a section of an F4-TCNQ layer formed in Comparative Example 2.
Fig. 8 is a diagram showing the energy level of each constituting member in a conventional organic EL device.
Fig. 9 is a view for explaining the motion of electrons and holes when an acceptor is added to a hole-injecting layer in the conventional organic EL device.

### Description of the Preferred Embodiments

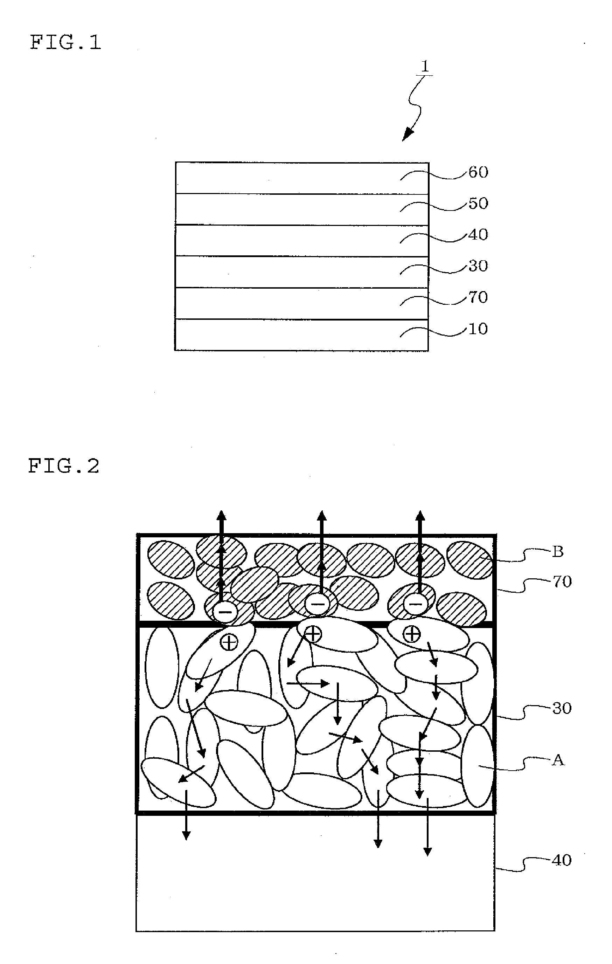

The organic EL device of the invention includes an emitting layer interposed between an anode and a cathode, an acceptor-containing layer and a hole-transporting layer, and the acceptor-containing layer and the hole-transporting layer are disposed between the anode and the emitting layer in this order from the anode. Fig. 1 illustrates a device structure of a first embodiment of the organic EL device according to the invention.
As illustrated in Fig. 1, an organic EL device 1 has a structure wherein an anode 10, an acceptor-containing layer 70, a hole-transporting layer 30, an emitting layer 40, an electron-transporting layer 50, and a cathode 60 are stacked in this order.

In this device, the acceptor contained in the acceptor-containing layer 70 withdraws electrons from a contacting surface present between the layer 70 and the hole-transporting layer 30, and simultaneously holes are generated. The acceptor-containing layer 70 has electron-transportability, and thus the electrons are transported from this contacting surface in the direction toward the anode 10 into the acceptor-containing layer 70. Furthermore, the holes are transported from the contacting surface in the direction toward the emitting layer 40 into the hole-transporting layer 30. On the other hand, electrons are injected from the cathode 60 to the electron-transporting layer 50, and further injected to the emitting layer 40. In the emitting layer 40, the holes are recombined with the electrons to emit light.
When electrons are injected from the emitting layer 40 to the hole-transporting layer 30, the electrons in the hole-transporting layer 30 flow into the acceptor-containing layer 70 so as to suppress the deterioration of the hole-transporting layer 30.

With reference to Fig. 2, the motion of electrons and holes in the acceptor-containing layer, the hole-transporting layer and emitting layer is described. The acceptor-containing layer 70 is made of an acceptor molecule B, and the hole-transporting layer 30 is made of a hole-transporting molecule A. Based on the acceptor molecule B, holes and electrons are generated in or near the interface between the acceptor-containing layer 70 and the hole-transporting layer 30. The holes are shifted in the hole-transporting layer 30 by the hole-transporting molecule A to be injected into the emitting layer 40. On the other hand, the electrons are shifted in the direction toward the anode (not illustrated) in the acceptor-containing layer 70.

As described above, in conventional devices, their hole-injecting layer has no electron transportability; therefore, injected electrons are present in the hole-transporting layer or the hole-injecting layer until the electrons are recombined with holes, and thus, cause deterioration of these layers.
However, even if electrons are injected from the emitting layer to the hole-transporting layer in the invention, the hole-transporting layer can be prevented from being deteriorated since the electrons flow from the electron-transportable acceptor-containing layer to the anode.

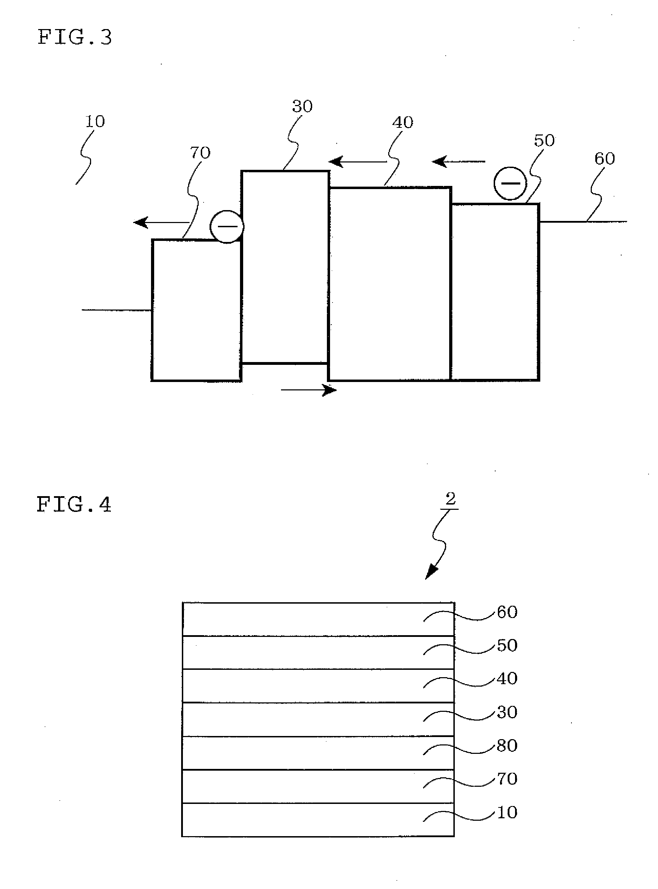

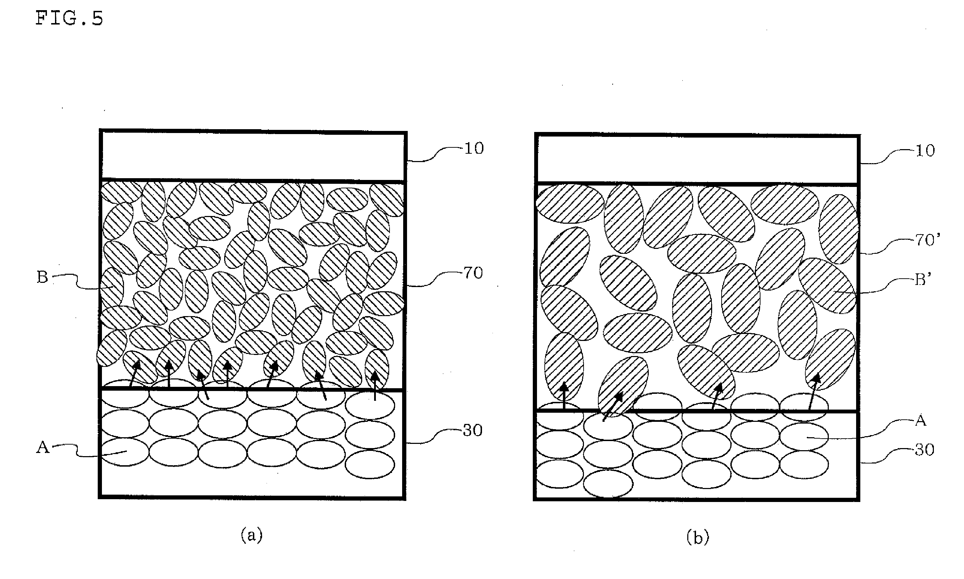

Further Fig. 3 shows the energy level of each of the constituting members in the organic EL device shown in Fig. 1.
Since the acceptor-containing layer 70 has a high ionization potential as illustrated in this figure, no energy barrier is present between the layer 70 and the hole-transporting layer 30.
In the present embodiment, therefore, it is unnecessary that holes go over the energy barrier E illustrated in Fig. 5, as in conventional devices. Thus, the voltage applied thereto is decreased. In other words, according to the device structure of the organic EL device of the embodiment, the device neither suffer any voltage loss in the energy barrier against hole injection which is present between the hole-injecting layer and the hole-transporting layer nor any voltage loss in the energy barrier against hole injection which is present between the anode and the hole-injecting layer. Accordingly, the voltage necessary for the device can be made low.

The acceptor used in the embodiment will be described later.
The device structure of the organic EL device of the invention is not limited to the structure illustrated in Fig. 1. For example, an electron-injecting layer is disposed, or the emitting layer can be made into a stacked body composed of two or more layers emitting different colors.
The hole-transporting layer can be made into a stacked body composed of two or more layers. For example, first and second hole-transporting layers which are made of different compounds can be disposed between the acceptor-containing layer and the emitting layer.

A second embodiment of the organic EL device will be described hereinafter.
Fig. 4 is a sectional view illustrating the second embodiment of the organic EL device according to the invention.
This embodiment is different from the first embodiment in that a buffer layer 80 is disposed between the acceptor-containing layer 70 and the hole-transporting layer 30.

The buffer layer is a layer which generates an electric charge by itself, or a layer in which an electric charge is present in itself. Specific examples thereof include a doped layer, an electroconductive or semiconductive inorganic compound layer, an alkali metal layer, a metal halide layer, a metal complex layer, any combination thereof, and a combination of a metal complex layer and an Al thin layer reactive therewith. The buffer layer is preferably a doped layer or a semiconductive inorganic compound layer.

According to the device structure illustrated in Fig. 4, electrons are transported in the direction toward the anode from the buffer layer, which is present between the acceptor-containing layer and the hole-transporting layer, into the acceptor-containing layer while holes are transported in the direction toward the emitting layer from the buffer layer, which is present between the acceptor-containing layer and the hole-transporting layer, into the hole-transporting layer.
Since the carriers (electrons or holes) contributing to electric conduction are present in the buffer layer, the energy which the acceptor-containing layer requires for the withdrawing of the electrons is small. Thus, the voltage necessary for the device can be made lower.

In the case that the buffer layer is a doped layer, the doped layer is preferably an electron-transportable compound layer to which a reducing agent is added (an N doped layer), a hole-transportable compound layer to which an oxidizer or an acceptor (easily-reducible organic compound) which will be detailed later is added (a P doped layer), or a stacked body composed of an N doped layer and a P doped layer. The added amount of the oxidizer or the reducing agent is usually 20% or less by weight.

As the reducing agent, there is preferably used an alkali metal, an alkaline earth metal, a rare earth metal, an alkali metal complex, an alkaline earth metal complex, a rare earth metal complex, an alkali metal halide, an alkaline earth metal halide, a rare earth metal halide or the like.
As the oxidizer, a Lewis acid, an acceptor which will be detailed later or the like is preferably used. Preferred examples of the Lewis acid include iron chloride, antimony chloride, and transition metal oxides such as vanadium oxide and molybdenum oxide.

As the electron transporting compound, known compounds may be used, but a metal complex of 8-hydroxyquinoline or a derivative thereof may preferably be used.
Specific examples of the above-mentioned metal complex of 8-hydroxyquinoline or derivative include metal chelate oxynoid compounds (for example, Alq) containing a chelate of oxine (generally, 8-quinolinol or 8-hydroxyquinoline).

As the electron transporting compound, an oxadiazole derivative may preferably be used. Examples of the oxadiazole derivative include electron-transferring compounds represented by the following general formulae: 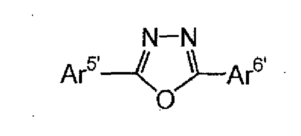 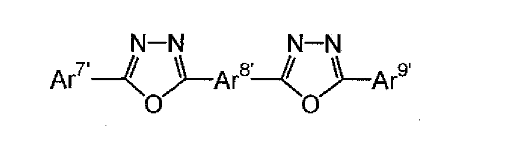 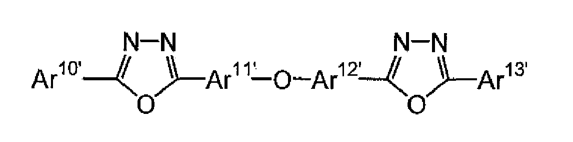 wherein Ar^{5'}, Ar^{6'}, Ar^{7'}, Ar^{9'}, Ar^{10'} and Ar^{13'} each represent a substituted or unsubstituted aryl group and may be the same as or different from each other, and Ar^{8'}, Ar^{11'} and Ar^{12'} represent substituted or unsubstituted arylene groups and may be the same as or different from each other.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbon atoms, alkoxy groups with 1 to 10 carbon atoms, and a cyano group. The electron transferring compounds are preferably ones having capability of forming a thin film.

Specific examples of the electron transferring compounds include the following:

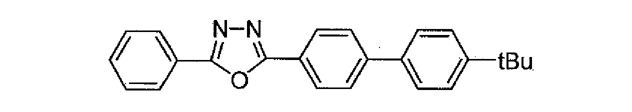

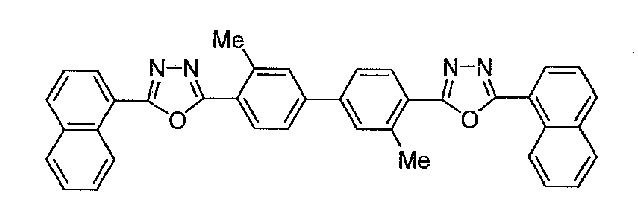

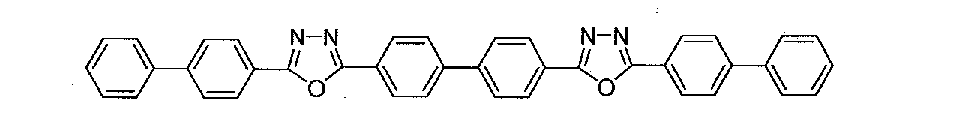

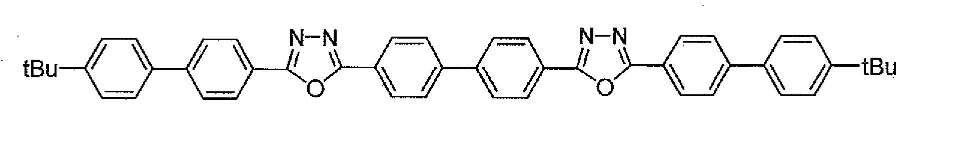

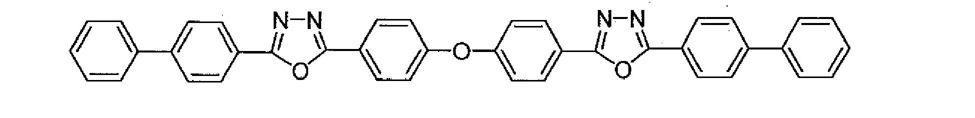

Nitrogen-containing heterocyclic derivatives represented by the following formula: 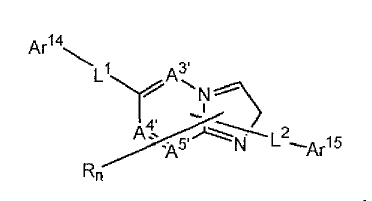 wherein A^{3'} to A^{5'} are each a nitrogen atom or a carbon atom.
R is an aryl group which has 6 to 60 carbon atoms and may have a substituent, a heteroaryl group which has 3 to 60 carbon atoms and may have a substituent, an alkyl group which has 1 to 20 carbon atoms, a haloalkyl group which has 1 to 20 carbon atoms, or an alkoxy group which has 1 to 20 carbon atoms; n is an integer of 0 to 5 and when n is an integer of 2 or more, Rs may be the same as or different from each other.
Adjacent Rs may be bonded to each other to form a substituted or unsubstituted carbocyclic aliphatic ring or a substituted or unsubstituted carbocyclic aromatic ring.
Ar¹⁴ is an aryl group which has 6 to 60 carbon atoms and may have a substituent, or a heteroaryl group which has 3 to 60 carbon atoms and may have a substituent.
Ar¹⁵ is a hydrogen atom, an alkyl group which has 1 to 20 carbon atoms, a haloalkyl group which has 1 to 20 carbon atoms, an alkoxy group which has 1 to 20 carbon atoms, an aryl group which has 6 to 60 carbon atoms and may have a substituent, or a heteroaryl group which has 3 to 60 carbon atoms and may have a substituent.
Provided that either one of Ar¹⁴ and Ar¹⁵ is a condensed cyclic group which has 10 to 60 carbon atoms and may have a substituent or a condensed heterocyclic group which has 3 to 60 carbon atoms and may have a substituent.
L¹ and L² are each a single bond, a condensed cyclic group which has 6 to 60 carbon atoms and may have a substituent, a condensed heterocyclic group which has 3 to 60 carbon atoms and may have a substituent, or a fluorenylene group which may have a substituent.

Nitrogen-containing heterocyclic derivatives represented by the following formula:

HAr-L³-Ar¹⁶-Ar¹⁷

wherein HAr is a nitrogen-containing heterocyclic ring with 3 to 40 carbon atoms which may have a substituent;
L³ is a single bond, an arylane group with 6 to 60 carbon atoms which may have a substituent, a heteroarylane group with 3 to 60 carbon atoms which may have a substituent or a fluorenylene group which may have a substituent;
Ar¹⁶ is a bivalent aromatic hydrocarbon group with 6 to 60 carbon atoms which may have a substituent; and
Ar¹⁷ is an aryl group with 6 to 60 carbon atoms which may have a substituent or a heteroaryl group with 3 to 60 carbon atoms which may have a substituent.

An electroluminescence device using a silacyclopentadiene derivative represented by the following formula, disclosed in JP-A-09-087616: 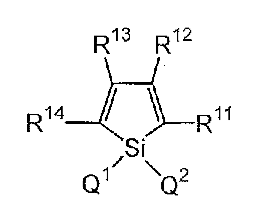 wherein Q¹ and Q² are each a saturated or unsaturated hydrocarbon group with 1 to 6 carbon atoms, an alkoxy group, an alkenyloxy group, an alkynyloxy group, a hydroxyl group, a substituted or unsubstituted aryl group, or a substituted or unsubstituted hetero ring, or Q¹ and Q² are bonded to each other to form a saturated or unsaturated ring; R¹¹ to R¹⁴ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoil group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group or a cyano group, or adjacent groups of R¹¹ to R¹⁴ may be joined to form a substituted or unsubstituted condensed ring.

Silacyclopentadiene derivative represented by the following formula, disclosed in JP-A-09-194487: 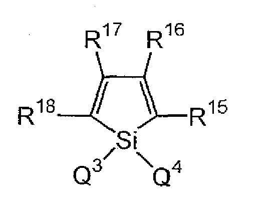 wherein Q³ and Q⁴ are each a substituted or unsubstituted hydrocarbon group with 1 to 6 carbon atoms, an alkoxy group, an alkenyloxy group, an alkynyloxy group, a substituted or unsubstituted aryl group, or a substituted or unsubstituted heterocyclic group, or Q³ or Q⁴ are bonded to each other to form a substituted or unsubstituted ring; R¹⁵ to R¹⁸ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoil group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group, a cyano group, or a substituted or unsubstituted condensed ring structure formed by adjacent substituents of R¹⁵ to R¹⁸: however, in the case where R¹⁵ and R¹⁸ are each a phenyl group, Q³ and Q⁴ are neither an alkyl group nor a phenyl group; in the case where R¹⁵ and R¹⁸ are each a thienyl group, Q³, Q⁴, R¹⁶ and R¹⁷ do not form the structure where Q³ and Q⁴ are a monovalent hydrocarbon group, and at the same time R¹⁶ and R¹⁷ are an alkyl group, an aryl group, an alkenyl group, or an aliphatic group with a cycle formed by R¹⁶ and R¹⁷ bonded; in the case where R¹⁵ and R¹⁸ are a silyl group, R¹⁶, R¹⁷, Q³ and Q⁴ are each neither a monovalent hydrocarbon group with 1 to 6 carbon atoms nor a hydrogen atom; and in the case where R¹⁵ and R¹⁶ are bonded to form a condensed structure with a benzene ring, Q³ and Q⁴ are neither an alkyl group nor a phenyl group.

Borane derivatives represented by the following formula, disclosed in JP-A1-2000-040586: 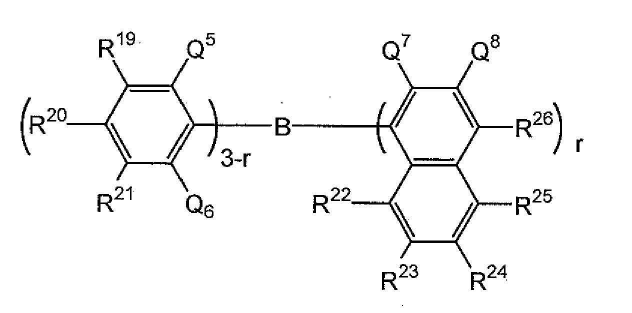 wherein R¹⁹ to R²⁶ and Q⁸ are each a hydrogen atom, a saturated or unsaturated hydrocarbon group, an aromatic group, a heterocyclic group, a substituted amino group, a substituted boryl group, an alkoxy group or an aryloxy group; Q⁵, Q⁶ and Q⁷ are each a saturated or unsaturated hydrocarbon group, an aromatic group, a heterocyclic group, a substituted amino group, an alkoxy group or an aryloxy group; the substituents of Q⁷ and Q⁸ may be bonded to each other to form condensed rings; r is an integer of 1 to 3, and Q⁷s may be different from each other when r is 2 or more; provided that excluded are the compounds where r is 1, Q⁵, Q⁶ and R²⁰ are each a methyl group and R²⁶ is a hydrogen atom or a substituted boryl group, and the compounds where r is 3 and Q⁷ is a methyl group.

Compounds represented by the following formula, disclosed in JP-A-10-088121: 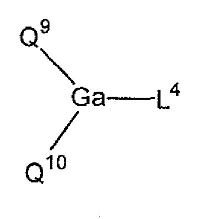 wherein Q⁹ and Q¹⁰ are independently a ligand represented by the following formula; and L⁴ is a halogen atom, a substituted or unsubstituted alkyl group, a substituted or unsubstituted cycloalkyl group, a substituted or unsubstituted aryl group, a substituted or unsubstituted heterocyclic group, -OR²⁷ wherein R²⁷ is a hydrogen atom, a substituted or unsubstituted alkyl group, a substituted or unsubstituted cycloalkyl group, a substituted or unsubstituted aryl group, a substituted or unsubstituted heterocyclic group, or -O-Ga-Q¹¹(Q¹²) wherein Q¹¹ and Q¹² are the same ligands as Q⁹ and Q¹⁰.

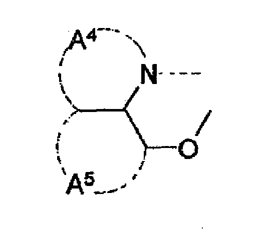

wherein rings A⁴ and A⁵ are each a 6-membered aryl ring structure which may have a substituent, and are condensed to each other.

The metal complexes have the strong nature of an n-type semiconductor and great capability of injecting electrons. Further the energy generated at the time of forming a complex is small so that a metal is then strongly bonded to ligands in the complex formed and the fluorescent quantum efficiency becomes large as the emitting material.

Specific examples of the rings A⁴ and A⁵ which form the ligands of the above formula include halogen atoms such as chlorine, bromine, iodine and fluorine; substituted or unsubstituted alkyl groups such as methyl, ethyl, propyl, butyl, sec-butyl, tert-butyl, pentyl, hexyl, heptyl, octyl, stearyl and trichloromethyl; substituted or unsubstituted aryl groups such as phenyl, naphthyl, 3-methylphenyl, 3-methoxyphenyl, 3-fluorophenyl, 3-trichloromethylphenyl, 3-trifluoromethylphenyl and 3-nitrophenyl; substituted or unsubstituted alkoxy groups such as methoxy, n-butoxy, tert-butoxy, trichloromethoxy, trifluoroethoxy, pentafluoropropoxy, 2,2,3,3-tetrafluoropropoxy, 1,1,1,3,3,3-hexafluoro-2-propoxy and 6-(perfluoroethyl)hexyloxy; substituted or unsubstituted aryloxy groups such as phenoxy, p-nitrophenoxy, p-tert-butylphenoxy, 3-fluorophenoxy, pentafluorophenyl and 3-trifluoromethylphenoxy; substituted or unsubstituted alkylthio groups such as methythio, ethylthio, tert-butylthio, hexylthio, octylthio and trifruoromethyltio; substituted or unsubstituted arylthio groups such as phenylthio, p-nitrophenylthio, p-tert-butylphenylthio, 3-fluorophenylthio, pentafluorophenylthio and 3-trifluoromethylphenylthio; a cyano group; a nitro group, an amino group; mono or di-substituted amino groups such as methylamino, dimethylamino, ethylamino, diethylamino, dipropylamino, dibutylamino and diphenylamino; acylamino groups such as bis(acetoxymethyl)amino, bis(acetoxyethyl)amino, bis(acetoxypropyl)amino and bis(acetoxybutyl)amino; a hydroxy group; a siloxy group; an acyl group; substituted or unsubstituted carbamoyl groups such as carbmoyl, methylcarbamoyl, dimethylcarbamoyl, ethylcarbamoyl, diethylcarbamoyl, propylcarbamoyl, butylcarbamoyl and phenylcarbamoyl; a carboxylic group; a sulfonic acid group; an imido group; cycloalkyl groups such as cyclopentyl and cyclohexyl; aryl groups such as phenyl, naphthyl, biphenyl, anthranyl, phenanthryl, fluorenyl and pyrenyl; and heterocyclic groups such as pyridinyl, pyrazinyl, pyrimidinyl, pryidazinyl, triazinyl, indolinyl, quinolinyl, acridinyl, pyrrolidinyl, dioxanyl, piperidinyl, morpholidinyl, piperazinyl, triathinyl, carbazolyl, furanyl, thiophenyl, oxazolyl, oxadiazolyl, benzooxazolyl, thiazolyl, thiadiazolyl, benzothiazolyl, triazolyl, imidazolyl, benzoimidazolyl and puranyl. Moreover the above-mentioned substituents may be bonded to each other to form a six-membered aryl or heterocyclic ring.

As the hole transporting compound, known compounds may be used.
Specific examples thereof include triazole derivatives (see USP No. 3, 112, 197 and others), oxadiazole derivatives (see USP No. 3,189,447 and others), imidazole derivatives (see JP-B-37-16096 and others), polyarylalkane derivatives (see USP No. 3,615,402, 3,820,989 and 3,542,544, JP-B-45-555 and 51-10983, JP-A-51-93224, 55-17105, 56-4148, 55-108667, 55-156953 and 56-36656, and others), pyrozoline derivatives and pyrozolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3, 526, 501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP No. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive macromolecular oligomers (in particular thiophene oligomers) disclosed in JP-A-1-211399.

The formation of the N-doped layer makes it possible that the acceptor-containing layer withdraws a larger number of electrons to make the driving voltage of the organic EL device lower.

The formation of the P-doped layer makes it possible that a larger number of holes are sent to the hole-transporting layer to make the driving voltage of the organic EL device lower.

The formation of the stacked body composed of an N-doped layer and a P-doped layer makes it possible that the acceptor-containing layer withdraws a larger number of electrons and further a larger number of holes are sent to the hole-transporting layer to make the driving voltage of the organic EL device lower still.

In the case that the buffer layer is a semiconductive inorganic compound layer, the semiconductive inorganic compound layer is preferably made of a transition metal oxide. Specific examples of the transition metal oxide include NbO, LaO, NdO, SmO, EuOₓ, MoO₃, MoO₂, ReO₂, ReO₃, OsO₂, IrO₂, and PtO₂. Preferred are LiTi₂O₄, LiV₂O₄, ErₓNbO₃, LaTiO₃, SrVO₃, CaCrO₃, SrₓCrO₃, AₓMoO₃, and AV₂O₅ wherein A = K, Cs, Rb, Sr, Na, Li or Ca.
The same advantageous effects as produced by the doped layer can also be expected by the formation of the semiconductive inorganic compound layer.

The following will describe the acceptor.
The acceptor is an easily-reducible organic compound.
The easiness of the reduction of a compound can be measured based on the reduction potential thereof. In the invention, the acceptor is preferably a compound having a reduction potential of -0.8 V or more, and is more preferably a compound having a higher reduction potential than that (approximately 0 V) of tetracyanoquinodimethane (TCNQ). The reduction potential is a reduction potential measured by use of a saturated calomel electrode (SCE) as a reference electrode.

The easily-reducible organic compound is preferably an organic compound having an electron-withdrawing substituent. Specific examples thereof include quinoide derivatives, pyrazine derivatives, arylborane derivatives, and imide derivatives. Examples of the quinoide derivatives include quinodimethane derivatives, thiopyrandioxide derivatives, thioxanthendioxide derivatives and quinone derivatives.

Preferred quinoid derivatives include compounds of formulae (1a) to (1i). More preferred quinoid derivatives are compounds of formulae (1a) and (1b). These each are the hole-injecting material for an organic EL device of the invention.

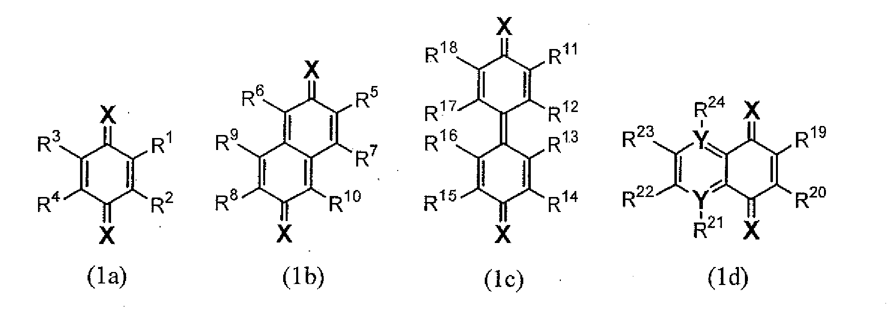

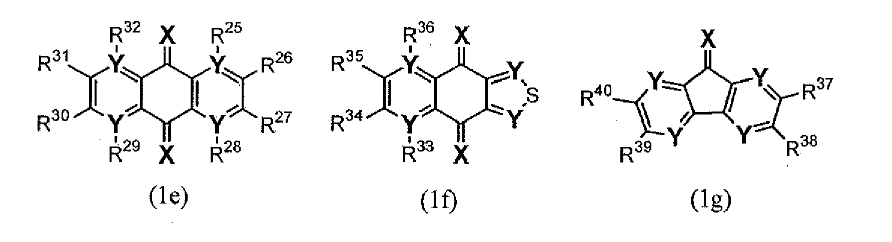

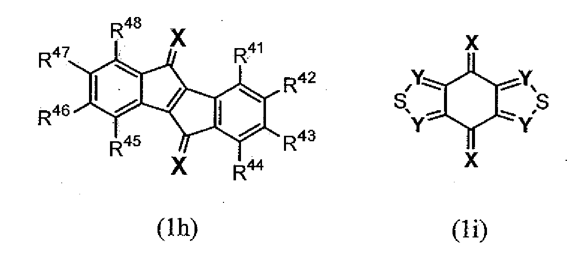

In formulae (1a) to (1i), R¹ to R⁴⁸ are each a hydrogen atom, halogen atom, fluoroalkyl group, cyano group, alkoxy group, alkyl group or aryl group, preferably a hydrogen atom or cyano group.
In formulae (1a) to (1i), X is an electron-withdrawing group of formulae (j) to (p), preferably (j), (k) or (l), 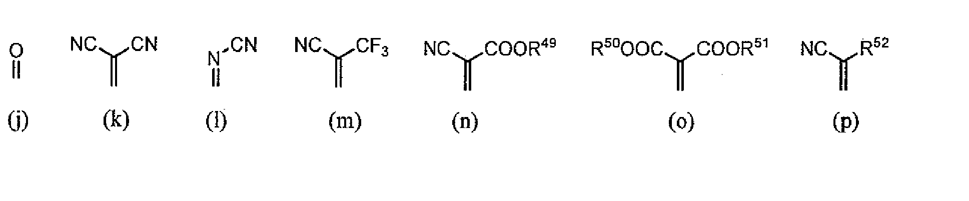 wherein R⁴⁹ to R⁵² are each a hydrogen atom, fluoroalkyl group, alkyl group, aryl group or heterocycle, and R⁵⁰ and R⁵¹ may form a ring.
In formulae (1a) to (1i), Y is -N= or -CH=.

As the halogen of R¹ to R⁴⁸, fluorine and chlorine are preferred.

As the fluoroalkyl group of R¹ to R⁴⁸, trifluoromethyl and pentafluoroethyl groups are preferred.

As the alkoxy group of R¹ to R⁴⁸, methoxy, ethoxy, iso-propoxy and tert-butoxy groups are preferred.
As the alkyl group of R¹ to R⁴⁸, methyl, ethyl, propyl, iso-propyl, tert-butyl and cyclohexyl groups are preferred.

As the aryl group of R¹ to R⁴⁸, phenyl and naphthyl groups are preferred.

The fluroalkyl, alkyl and aryl groups of R⁴⁹ to R⁵² are the same as those of R¹ to R⁴⁸.

As the heterocylce of R⁴⁹ to R⁵², substituents shown by the following formulae are preferred.

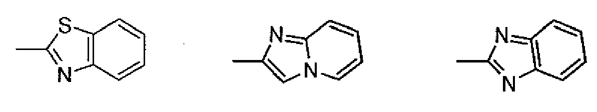

When R⁵⁰ and R⁵¹ form a ring, X is preferably a substituent of the following formula, 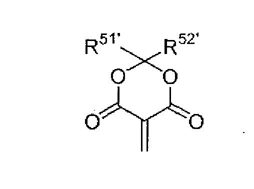 wherein R^{51'} and R^{52'} are each a methyl, ethyl, propyl or tert-butyl group.

Specific examples of the quinoid derivatives include the following compounds.

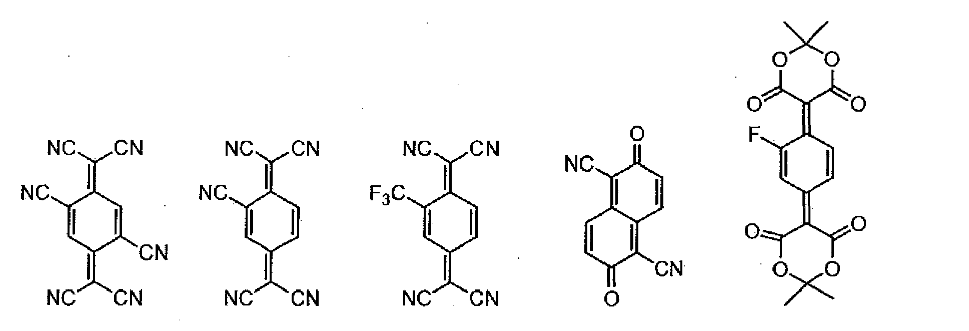

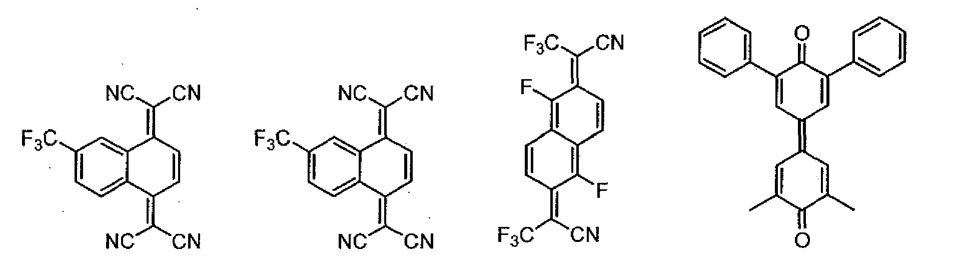

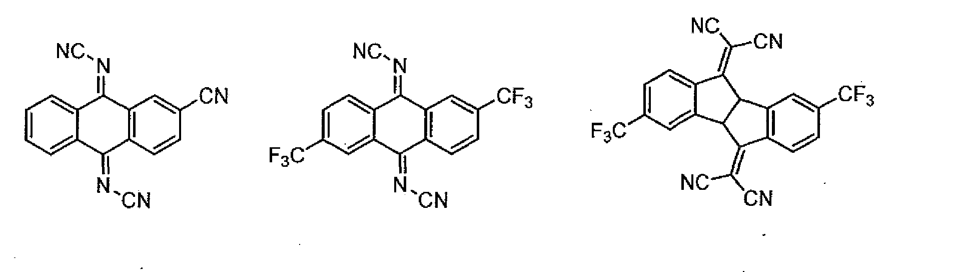

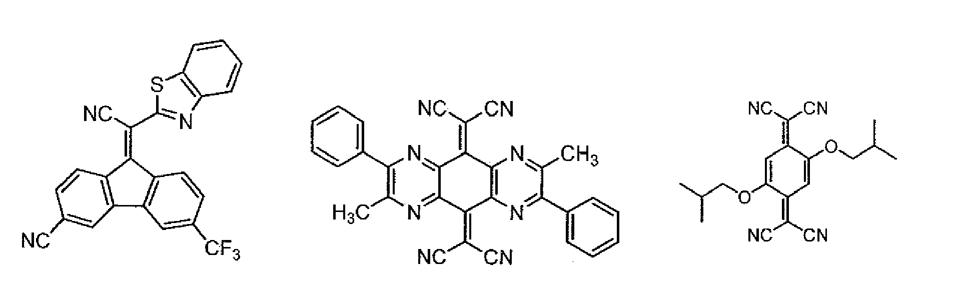

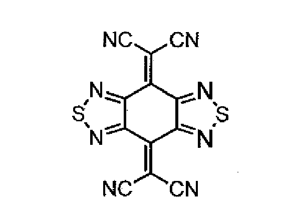

The arylborane derivatives include compounds of the following formula (2a) or (2b).

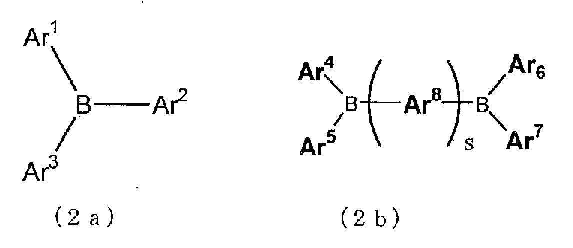

In formulae (2a) and (2b), Ar¹ to Ar⁸ are each an aryl group or heterocycle having an electron-withdrawing group.
As the aryl group having an electron-withdrawing group of Ar¹ to Ar⁸, pentafluorophenyl, pentafluoronaphthyl and pentafluorophenyl groups are preferred.
As the heterocycle having an electron-withdrawing group of Ar¹ to Ar⁸, quinoline, quinoxaline, pyridine and pyrazine rings are preferred.

Specific examples of the arylborane derivatives include the following compounds.

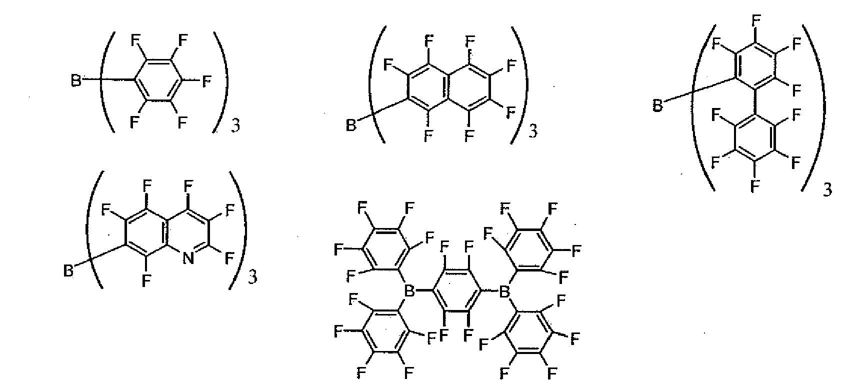

Preferred examples of the arylborane derivatives include compounds having at least one fluorine as a substituent positioned on the aryl. Particularly preferred is tris β-(pentafluoronaphthyl)borane (PNB).

The thiopyrane dioxide derivatives include compounds of the following formula (3a), and the thioxanthenedioxide derivatives include compounds of the following formula (3b).

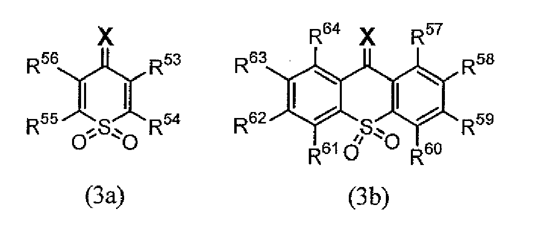

In formulae (3a) and (3b), R⁵³ to R⁶⁴ are each a hydrogen atom, halogen atom, fluoroalkyl group, cyano group, alkyl group or aryl group, preferably a hydrogen atom or cyano group.
In formulae (3a) and (3b), X shows an electron-withdrawing group, and is the same as X of formulae (1a) to (1i). X preferably has the structure of (i), (j) or (k).

The halogen, fluoroalkyl, alkyl and aryl groups of R⁵³ to R⁶⁴ are the same as those of R¹ to R⁴⁸.

Specific examples of the thiopyranedioxide derivatives shown by formula (3a) and thioxanthenedioxide derivatives shown by formula (3b) are as follows. 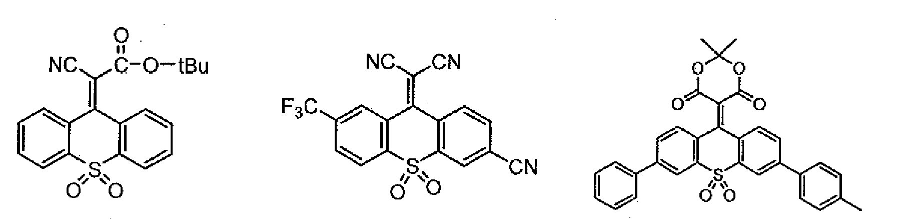 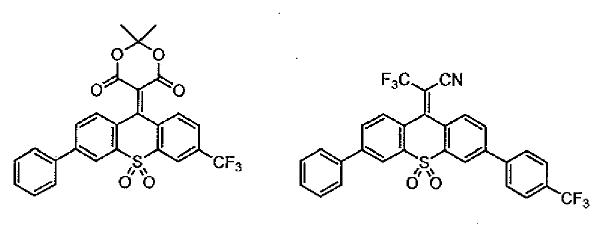 wherein tBu is a t-butyl group.

Furthermore, in formulae (1a) to (1i) and (3a) to (3b), the electron-withdrawing group X may be a substituent (x) or (y) represented by the following formulae:

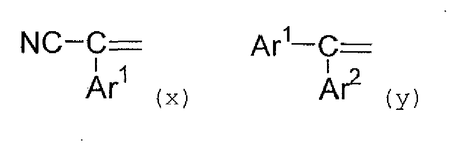

In the formula, Ar¹ and Ar² are a substituted or unsubstituted heterocycle, substituted or unsubstituted aryloxycarbonyl or aldehyde, and are preferably pyridine, pyrazine, or quinoxaline. Ar¹ and Ar² may be bonded to each other to form a 5-membered or 6-membered cyclic structure.

Preferred examples of the imide derivatives include naphthalene tetracarboxylic acid diimide compounds and pyromellitic acid diimide compounds.

In the invention, an acceptor is contained in the acceptor-containing layer so that the layer can transport electrons. The acceptor content is preferably more than 20% by weight of the total of the layer. In order to cause the electron mobility of the acceptor-containing layer to be more than 10⁻⁵, the acceptor content is more preferably 40% or more by weight, even more preferably 50% or more by weight.

The acceptor-containing layer has electron-transportability, and this means that the layer is relatively electron-transportable rather than hole-transportable.
In order to confirm the electron-transportability of the acceptor-containing layer, various methods may be used. For example, the transportability can be confirmed by any one of the following methods (1) to (3):
(1) a method of sandwiching a thin film having a thickness of 2 to 10 µm and the same composition as the acceptor-containing layer between electrodes, then causing optical excitation therein by irradiating a laser ray from above the cathode, and then measuring the transient optical current (the time-of-flight or TOF method),
(2) a method of sandwiching a thin film having the same composition as the acceptor-containing layer between electrodes, the cathode thereof being an electron-injecting electrode made of Mg:Ag, Al/LiF or the like, applying a step-form voltage thereto, and then measuring the electron mobility by determining the shape of the transient current, and
(3) a method of sandwiching a thin film having the same composition as the acceptor-containing layer between electrodes wherein only electron injection is caused (for example, Al or Al/LiF), and then measuring the value of the current.

The acceptor-containing layer exists as a continuous film formed by deposition. For example, the use of the above compounds enables formation of a continuous film by deposition. The "continuous film" is one in which its material continuously exists without gaps from the surface of the film to a substrate on which the film the formed.
The surface of the acceptor-containing layer preferably has a plane roughness (Ra) of 1.5 nm or less, more preferably 1.0 nm or less. The plane roughness can be determined under an atom force microscope (AFM).
Fig. 5 shows the states of a continuous film (a) and non-continuous film (b).
In a non-continuous film or a film having a large plane roughness (Fig. 5(b)), when depositing an acceptor compound B' constituting an acceptor-containing layer 70', the grain size of the acceptor compound B' crystals becomes large. As a result, contact areas between the acceptor compound B' crystals and at the interfaces with upper and lower layers, e.g., hole-transporting layer 30 and anode 10, may become smaller, whereby current is difficult to flow, leading to an increased driving voltage and decreased efficiency.

An electron-donating compound may be added to the acceptor-containing layer. The amount of the electron-donating compound added is preferably smaller than the concentration of the acceptor. For example, the amount thereof is from 1 to 20% by weight of the total of the layer.
The addition of the electron-donating compound makes it possible to improve the electron-conductivity of the acceptor-containing layer to make the driving voltage of the organic EL device lower and prevent the hole-transporting layer from being deteriorated.
Examples of the electron-donating compound include inorganic materials such as alkali metals, alkaline earth metals, rare earth elements, Al, Ag, Cu and In; and organic materials such as anilines, phenylenediamines, benzidines (such as N,N,N',N'-tetraphenylbenzidine, N,N'-bis-(3-methylphenyl)-N,N'-bis-(phenyl)-benzidine, and N,N'-di(naphthalene-1-yl)-N,N'-diphenyl-benzidine), compounds having as their skeleton an aromatic tertiary amine such as triphenylamines (such as triphenylamine, 4,4',4"-tris(N,N-diphenyl-amino)-triphenylamine, 4,4',4"-tris(N-3-methylphenyl-N-phenyl-amino)-triphenylamine, and 4,4',4"-tris(N-(1-naphthyl)-N-phenyl-amino)-triphenylamine), and triphenyldiamines (such as N,N'-di-(4-methyl-phenyl)-N,N'-diphenyl-1,4-phenylenediamine), condensed polycyclic compounds (these condensed polycyclic compounds may have a substituent) such as pyrene, perylene, anthracene, tetracene and pentacene, and TTF (tetrathiafluvalene).

### [Examples]

Preferred electron-donating compounds include compounds of the following formula (4).

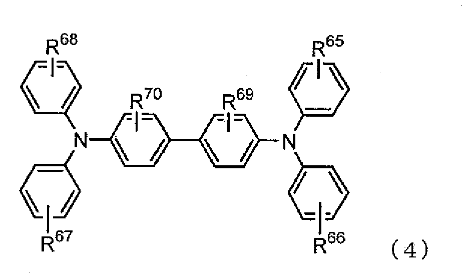

In formula (4), R⁶⁵ to R⁶⁸ are each a hydrogen atom, halogen atom, alkyl group, aryl group, heterocycle or diarylamino group and may be joined together to form a phenyl or naphthyl group.
In formula (4), R⁶⁹ to R⁷⁰ are each a hydrogen atom, halogen atom or alkyl group.

As the halogen atom of R⁶⁵ to R⁶⁸, fluorine and chlorine are preferred.

As the alkyl group of R⁶⁵ to R⁶⁸, methyl, ethyl, i-propyl, tert-butyl and cyclohexyl groups are preferred.

As the aryl group of R⁶⁵ to R⁶⁸, phenyl, naphthyl, fluorenyl, biphenyl and terphenyl groups are preferred.

As the heterocycle of R⁶⁵ to R⁶⁸, a carbazolyl group is preferred.

As the diarylamino group of R⁶⁵ to R⁶⁸, diphenylamino, phenyl-biphenylamino and biphenylamino groups are preferred.

The halogen atom and alkyl group of R⁶⁹ to R⁷⁰ are the same as those of R⁶⁵ to R⁶⁸.

The organic EL device of the invention preferably contains the compound of formula (4) in a hole-transporting layer. If the hole-transporting layer contains the compound, the organic EL device can emit light with a high efficiency at a low voltage.

### Example 1

### <Reduction potential of a material used in an acceptor-containing layer>

A compound A shown below was selected as a material for forming an acceptor-containing layer. In a cyclic voltammetric measurement thereof wherein a saturated calomel electrode (SCE) was used as a reference electrode, the reduction potential thereof was 0.71 V.

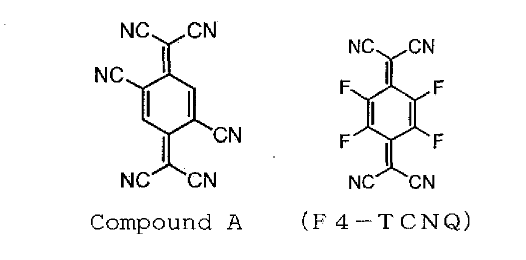

### <Confirmation of electron-transportability>

Al as an electrode material and the compound A as a material for forming an acceptor-containing layer were each mounted on a tungstent filament and a molybdenum heating boat of a vacuum deposition device, respectively. A 150 nm thick Al layer, a 200 nm thick layer made of the compound A, and a 150 nm thick Al layer were formed on a 0.7 mm thick glass substrate in this order. A voltage of 1 V was applied across the two Al electrodes, and the value of the current flowing therein was measured. The value was 251 mA/cm². Further, 250 nm thick Au layers, which Au was an electrode material, and a 100 nm thick layer made of the compound A were formed on the 0.7 mm thick glass substrate. The Au layers spaced 1 mm apart. A voltage of 10 V was applied across the two Au electrodes, and the value of the current flowing therein was measured. The value was 4 A/cm². For F4-TCNQ, similar measurement was conducted. The resultant current value was 15.7 mA/cm².

### (Fabrication of organic EL device)

An ITO film was formed on a 0.7 mm thick glass substrate by sputtering to a thickness of 130 nm. The substrate was subjected to ultrasonic cleaning in isopropyl alcohol for 5 minutes, and cleaned with ultraviolet ozone for 30 minutes. Then the substrate with the ITO electrode was mounted on a substrate holder in a vacuum vapor deposition apparatus.
The compound A as a material for an acceptor-containing layer, HT1 as a hole-transporting material, Alq₃ as a material for an emitting layer and an electron-transporting material, LiF as an electron-injecting material and Al as a cathode material were mounted on respective molybdenum heating boats in advance.

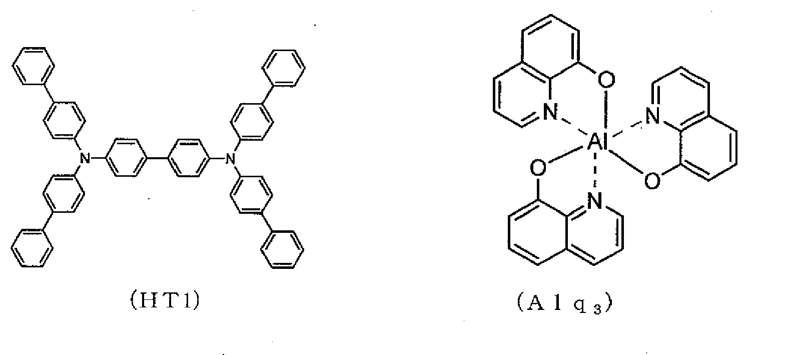

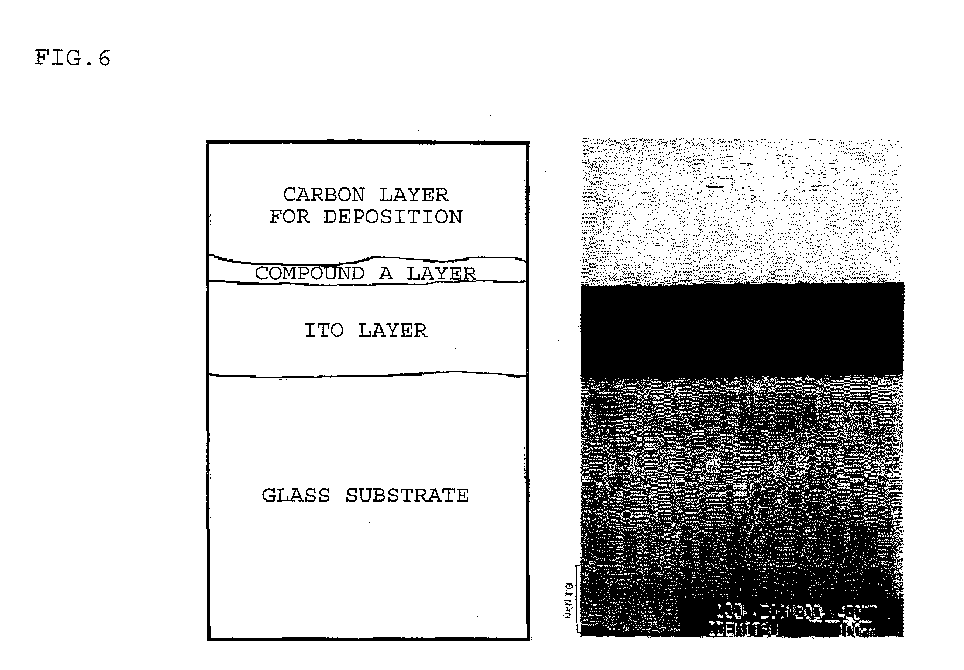

First, a compound A film which functioned as the acceptor-containing layer was formed in a thickness of 36 nm. After forming the acceptor-containing layer, a HT film which functioned as the hole-transporting layer was formed in a thickness of 40 nm. After forming the HT film, an Alq₃ film was formed in a thickness of 50 nm as the emitting layer and electron-transporting layer. Then an LiF film was deposited to a thickness of 1.2 nm as the electron-injecting layer, and an Al film which functioned as the cathode was formed thereon in a thickness of 250 nm to obtain an organic EL device. In the above fabrication, when the compound A film was formed to 36 nm on the ITO film, the compound A film was observed under a transmission electron microscope (TEM) (HF-2200, manufactures by Hitachi, Ltd.). The film was confirmed to be a continuous film (Fig. 6). Note that a carbon layer for deposition was formed to reduce damage due to thin film processing and to impart electrical conductivity. The compound A film was measured for plane roughness (Ra) under an atom force microscope (AFM) (AutoProbe M5, manufactured by TM Microscopes). The Ra was 0.7 nm.

### Comparative Example 2

An organic EL device was fabricated in the same manner as in Example 1 except that a 5 nm thick Al film was formed as an anode on the ITO film and the thickness of the HT1 film was 15 nm.

### Comparative Example 1

An organic EL device was fabricated in the same manner as in Example 1 except that no acceptor-containing layer film was formed, and the thickness of the HT1 film as the transporting layer was 106 nm.

### Comparative Example 2

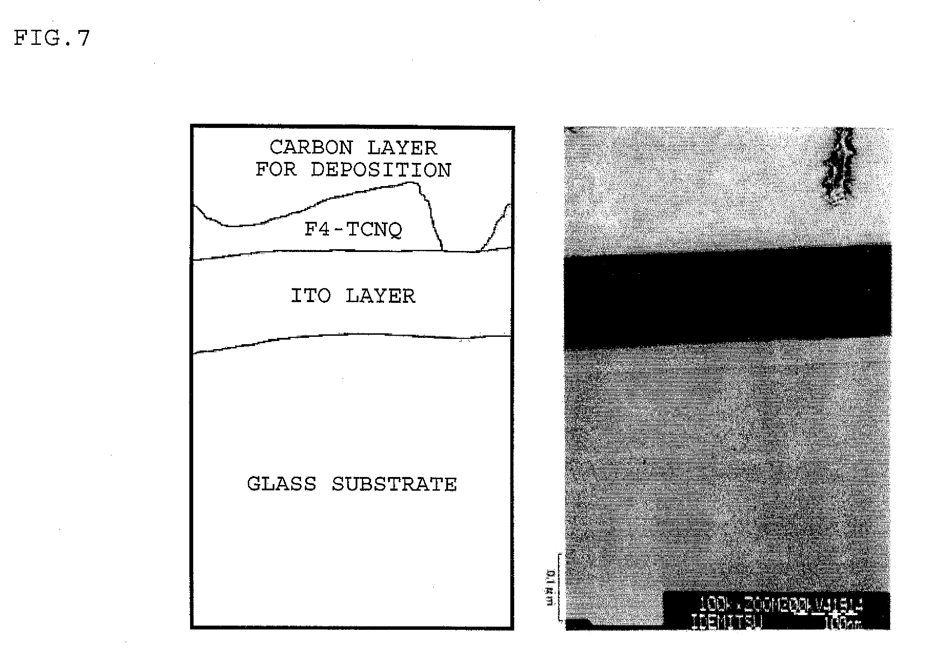

An organic EL device was fabricated in the same manner as in Comparative Example 1 except that F4-TCNQ was used in the acceptor-containing layer. When the 36 nm thick F4-TCNQ film, which thickness was determined with a film thickness meter, was formed on the ITO film, the F4-TCNQ film was observed under a TEM. The film was confirmed to have continuous gaps which reached the substrate (Fig. 7). The F4-TCNQ film was measured for plane roughness of the surface under an AFM to be 12.9 nm.

### (Evaluation of organic EL device)

The following evaluations were conducted for the organic EL devices obtained in Examples 1 to 4, and Comparative Examples 1 and 2. The results are shown in Table 1.
(1) Voltage (unit:V) at the time of applying a current between ITO and Al such that a current density was 10 mA/cm² was measured.
(2) Luminous efficiency (unit:cd/A) was calculated from EL spectrum at the time of applying voltage at a current density of 10 mA/cm².

Table 1 confirmed that the voltages were lowered, and equal or more luminous efficiencies were shown in Examples 1 and 2 compared with Comparative Examples 1 and 2. This was probably caused by the difference in the film state between the acceptor-containing layers as observed by a TEM and AFM. This shows that the continuity of a film or smoothness of a surface influenced voltage or efficiency.

Moreover, as shown in Example 2, even an electrode having a work function smaller than 4.8 eV such as Al electrode (work function of 4.1 eV) can emit light with a similar luminance at a lower voltage compared to heretofore. Considering that conventionally emissions could be observed only at a voltage exceeding 10 V, this shows that the invention has a great advantage.

The above Examples describe the bottom emission structure, but it is apparent that the invention can also be applied to the top emission structure. The invention can especially have a structure of reflective metal layer/acceptor-containing layer/organic medium including an emitting layer/light transparent cathode. For the reflective metal, Al, Ag, Ni, Mo, W, Ta, Ti, Cr and alloys thereof are often used. However, even when using metal or alloy layers having a work function smaller than 4.8 eV, light can be emitted at a low voltage. Conventionally where a reflective metal directly contacts a hole-transporting layer or hole-injecting layer, the voltage substantially increases.

### Example 3

An organic EL device was fabricated in the same manner as in Example 1 except that the compound (B) of the following formula was used as the acceptor-containing layer.

### Example 4

An organic EL device was fabricated in the same manner as in Example 1 except that the compound (C) of the following formula was used as the acceptor-containing layer.

### Example 5

An organic EL device was fabricated in the same manner as in Example 1 except that the compound (D) of the following formula was used as the acceptor-containing layer.

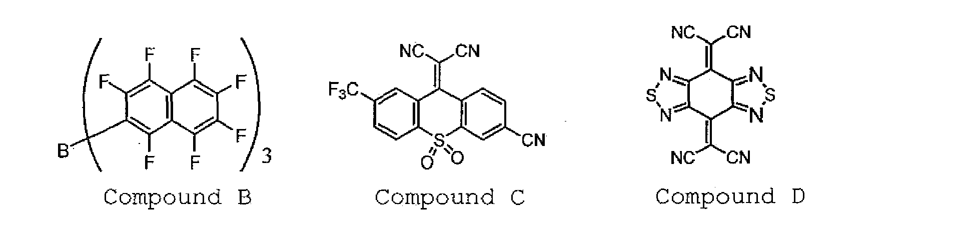

The organic EL devices fabricated in Examples 3 to 5 were evaluated in the same manner as in Example 1. Table 1 shows the results.

**Table 1**

| | Anode | Acceptor-containing layer | Hole-transporting layer | Setting layer (Electron-transporting layer) | Electron-injecting layer | Cathode | Voltage (V) | Luminous efficiency (cd/A) |
|---|---|---|---|---|---|---|---|---|
| Example 1 | ITO | Compound A | HT1 | Alq₃ | LiF | A1 | 6.2 | 1.11 |
| Example 2 | ITO/A1 | Compound A | HT1 | Alq₃ | LiF | A1 | 5.9 | 1.87 |
| Example 3 | ITO | Compound B | HT1 | Alq₃ | LiF | A1 | 6.6 | 1.14 |
| Example 4 | ITO | Compound C | HT1 | Alq₃ | LiF | A1 | 7.1 | 1.17 |
| Example 5 | ITO | Compound D | HT1 | Alq₃ | LiF | A1 | 6.4 | 1.12 |
| Comparative Example 1 | ITO | - | HT1 | Alq₃ | LiF | A1 | 8.6 | 1.08 |
| Comparative Example 2 | ITO | F4-TCNQ | HT1 | Alq₃ | LiF | A1 | 2.4 | 0.0003 |

### (Fabrication of organic EL device)

An ITO film was formed on a 0.7 mm thick glass substrate by using sputtering to a thickness of 130 nm. The substrate was subjected to ultrasonic cleaning in isopropyl alcohol for 5 minutes, and cleaned with ultraviolet ozone for 30 minutes. Then the substrate with the ITO electrode was mounted on a substrate holder in a vacuum vapor deposition apparatus.
The compound A as a material for an acceptor-containing layer, HT1 as a first hole-transporting material, HT2 as a second hole-transporting material, BH as a host material for an emitting layer, BD as a blue emitting material, Alq₃ as an electron-transporting material, LiF as an electron-injecting material and Al as a cathode material were mounted on respective molybdenum heating boats in advance. Moreover, MoO₃ was mounted as a semiconductive oxide material.

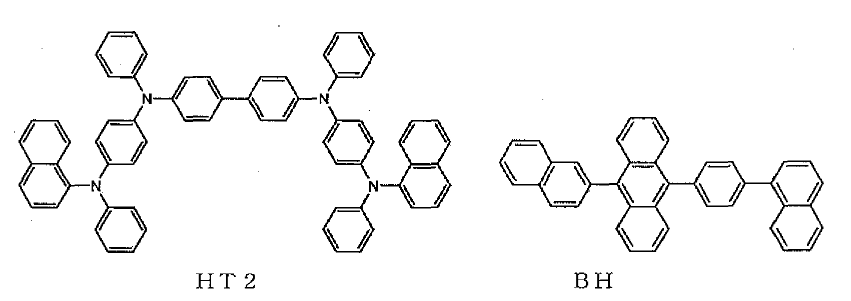

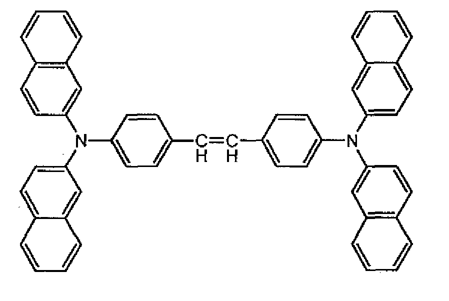

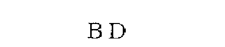

First, a compound A film which functioned as the acceptor-containing layer was formed in a thickness of 10 nm. After forming the acceptor-containing layer, a HT2 film which functioned as the second hole-transporting layer was formed in a thickness of 50 nm. Subsequently, a HT1 film which functioned as the first hole-transporting layer was formed in a thickness of 20 nm. After forming the HT1 film, a compound BH and compound BD were co-deposited in a thickness of 40 nm at a ratio of 40:2 as the emitting layer. An Alq₃ film was formed thereon in a thickness of 20 nm as the electron-transporting layer. Then an LiF film was deposited to a thickness of 1 nm as the electron-injecting layer, and an Al film which functioned as the cathode was formed thereon in a thickness of 150 nm to obtain an organic EL device.

### Comparative Example 3

An organic EL device was fabricated in the same manner as in Example 6 except that no acceptor-containing layer film was formed, and the thickness of the HT2 film as the second hole-transporting layer was 60 nm.

### Example 7

An organic EL device was fabricated in the same manner as in Example 6 except that after forming the acceptor-containing layer, a P-doped layer was formed in a thickness of 50 nm at a ratio of the second hole-transporting material HT2 to compound A of 100:5, and the HT1 film as the first hole-transporting layer was then formed in a thickness of 20 nm.

### Example 8

An organic EL device was fabricated in the same manner as in Example 6 except that after forming the acceptor-containing layer, a molybdenum oxide MoO₃ film was formed in a thickness of 5 nm.

### Example 9

An organic EL device was fabricated in the same manner as in Example 6 except that an Al film was formed on the ITO film in a thickness of 5 nm as an anode, and the thickness of the HT2 film was 15 nm.

Table 2 shows the structures of the organic EL devices fabricated in Examples 6 to 9 and comparative example 3. These organic EL devices were evaluated in the same manner as in Example 1. Table 3 shows the results.

**Table 2**

| | Anode | Acceptor-containing layer | Semi-conductive oxide layer | P-doped layer | Second hole-transporting layer | First hole-transporting layer | Emitting layer | Electron-transporting layer | Electron-injecting layer | Cathode |
|---|---|---|---|---|---|---|---|---|---|---|
| Example 6 | ITO | Compound A | - | - | HT2 | HT1 | BH/BD | Alq₃ | LiF | Al |
| Comparative Example 3 | ITO | - | - | - | HT2 | HT1 | BH/BD | Alq₃ | LiF | Al |
| Example 7 | ITO | Compound A | - | HT2/ Compound A | - | HT1 | BH/BD | Alq₃ | LiF | Al |
| Example 8 | ITO | Compound A | MoO₃ | - | HT2 | HT1 | BH/BD | Alq₃ | LiF | Al |
| Example 9 | ITO/Al | Compound A | - | - | HT2 | HT1 | BH/BD | Alq₃ | LiF | Al |

**Table 3**

| | Voltage (v) | CIE x | CIE y | Luminous efficiency (cd/A) |
|---|---|---|---|---|
| Example 6 | 6.3 | 0.15 | 0.17 | 6.1 |
| Comparative Example 3 | 6.9 | 0.15 | 0.17 | 6.3 |
| Example 7 | 5.8 | 0.15 | 0.18 | 6.6 |
| Example 8 | 6.2 | 0.15 | 0.17 | 6.0 |
| Example 9 | 6.0 | 0.12 | 0.18 | 7.9 |

### Industrial Applicability

The organic EL device of the invention can be used as organic EL materials for various colors including blue. The device can be used in fields such as various display devices, displays, back light, light sources, signs, signboards and interior; and especially suitable as a display device for color display.

## Claims

1. An organic electroluminescence device comprising:
an emitting layer between an anode and a cathode,
an acceptor-containing layer, and
a hole-transporting layer,
the acceptor-containing layer and the hole-transporting layer being disposed between the anode and the emitting layer in this order from the anode,
the acceptor-containing layer being a continuous film formed by deposition.

2. The organic electroluminescence device according to claim 1, wherein the acceptor-containing layer has a surface with a surface roughness (Ra) of 1.5 nm or less.

3. The organic electroluminescence device according to claim 1 or 2, wherein the reduction potential of the acceptor-containing layer is larger than the reduction potential of tetracyanoquinodimethane.

4. The organic electroluminescence device according to any one of claims 1 to 3, wherein the acceptor of the acceptor-containing layer is a quinoid derivative of formulae (1a) to (li), 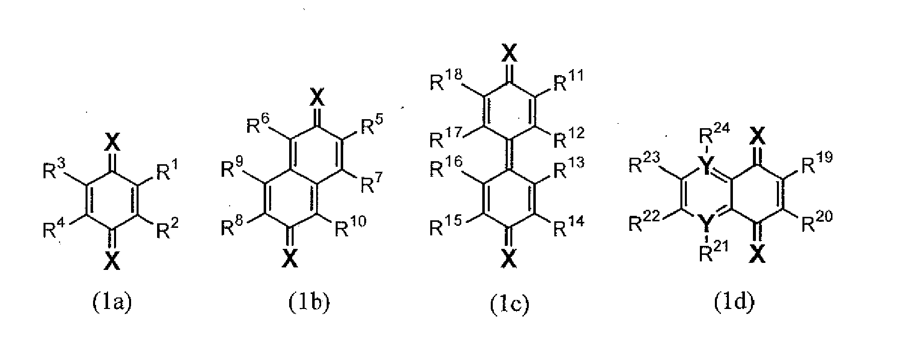 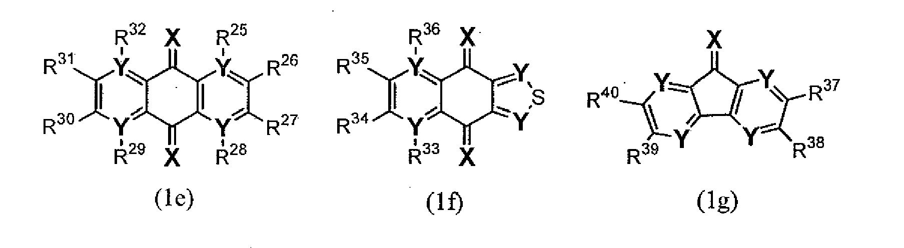 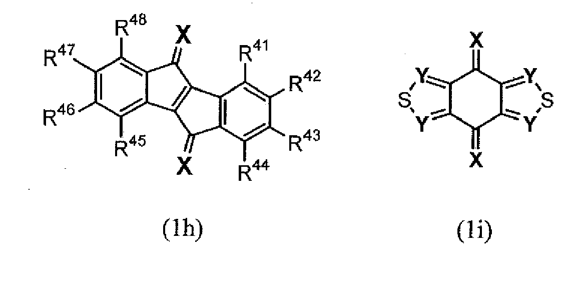 wherein R¹ to R⁴⁸ are each a hydrogen atom, halogen atom, fluoroalkyl group, cyano group, alkoxy group, alkyl group or aryl group, provided that derivatives of which all of R¹ to R⁴⁸ in the same molecule are hydrogen or fluorine are excluded, and
X is an electron-withdrawing group of formulae (j) to (p), 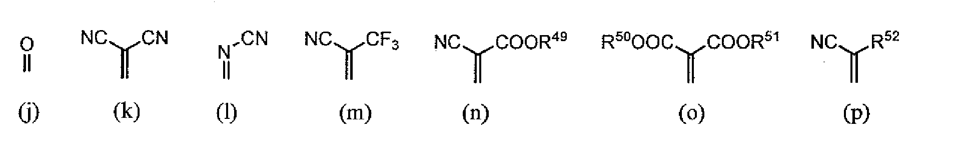 wherein R⁴⁹ to R⁵² are each a hydrogen atom, fluoroalkyl group, alkyl group, aryl group or heterocycle, and R⁵⁰ and R⁵¹ may form a ring, and
Y is -N= or -CH=.

5. The organic electroluminescence device according to any one of claims 1 to 3, wherein the acceptor of the acceptor-containing layer is an arylborane derivative of formula (2a) or (2b), 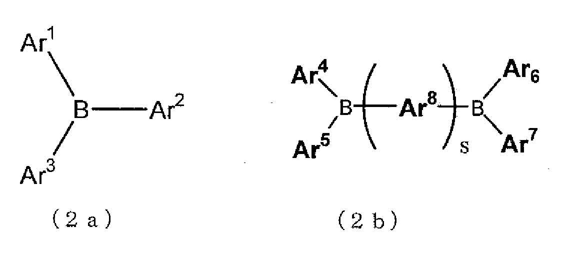 wherein Ar¹ to Ar⁸ are each an aryl group or heterocycle containing an electron-withdrawing group, and s is 1 or 2.

6. The organic electroluminescence device according to any one of claims 1 to 3, wherein the acceptor of the acceptor-containing layer is a thiopyranedioxide derivative of formula (3a) or a thioxanthenedioxide derivative of formula (3b), 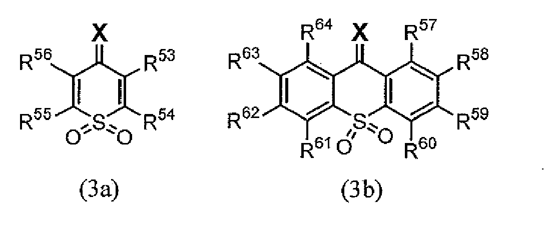 wherein R⁵³ to R⁶⁴ are each a hydrogen atom, halogen atom, fluoroalkyl group, cyano group, alkyl group or aryl group, and
X is an electron-withdrawing group of formulae (j) to (p), 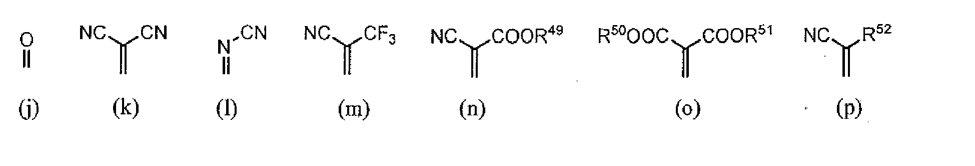 wherein R⁴⁹ to R⁵² are each a hydrogen atom, fluoroalkyl group, alkyl group, aryl group or heterocycle, and R⁵⁰ and R⁵¹ may form a ring.

7. The organic electroluminescence device according to any one of claims 1 to 6, wherein an electron-donating compound is added to the acceptor-containing layer in a concentration lower than the concentration of the acceptor.

8. The organic electroluminescence device according to claim 7, wherein the electron-donating compound is a phenylenediamine compound of formula (4), 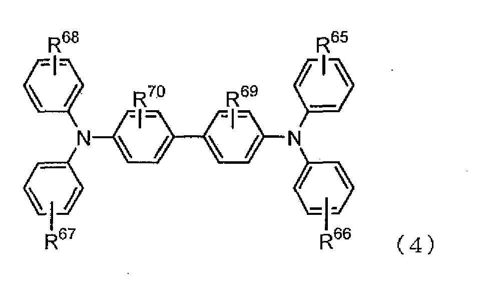 wherein R⁶⁵ to R⁶⁸ are each a hydrogen atom, halogen atom, alkyl group, aryl group, heterocycle or diarylamino group and may be joined together to form a phenyl or naphthyl group, and
R⁶⁹ to R⁷⁰ are each a hydrogen atom, halogen atom or alkyl group.

9. The organic electroluminescence device according to any one of claims 1 to 8, wherein the hole-transporting layer is a phenylenediamine compound of formula (4), 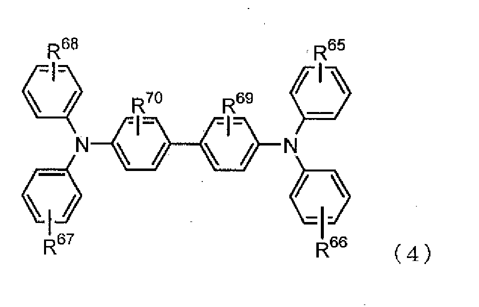 wherein R⁶⁵ to R⁶⁸ are each a hydrogen atom, halogen atom, alkyl group, aryl group, heterocycle or diarylamino group and may be joined together to form a phenyl or naphthyl group, and
R⁶⁹ to R⁷⁰ are each a hydrogen atom, halogen atom or alkyl group.

10. The organic electroluminescence device according to any one of claims 1 to 9, wherein a buffer layer is interposed between the acceptor-containing layer and the hole-transporting layer.

11. The organic electroluminescence device according to claim 10, wherein the buffer layer is a doped layer.

12. The organic electroluminescence device according to claim 11, wherein the doped layer is an N-doped layer and/or a P-doped layer.

13. The organic electroluminescence device according to claim 10, wherein the buffer layer is a semiconductive oxide layer.

14. The organic electroluminescence device according to any one of claims 1 to 13, wherein electrons are transported from the buffer layer or a contacting surface between the acceptor-containing layer and the hole-transporting layer into the acceptor-containing layer toward the anode, and
holes are transported from the buffer layer or the contacting surface between the acceptor-containing layer and the hole-transporting layer into the hole-transporting layer toward the emitting layer.

15. A hole-injecting material for an organic electroluminescence device comprising a quinoid derivative of formulae (1a) to (li) recited in claim 4.
